# EUROPEAN PATENT APPLICATION

(11) **EP 4 542 633 A1**
(43) Date of publication of application: **23.04.2025**
(21) Application number: 22949515.5
(22) Date of filing: 28.06.2022
(51) Int. Cl.: H01L 21/67, H01L 21/687

(54) **APPARATUS FOR MANUFACTURING MICRO LED DISPLAY**

(71) Applicant: LG Electronics Inc., Yeongdeungpo-gu Seoul 07336 (KR)
(72) Inventor: KIM, Seohyeon, Seoul 06772 (KR); KIM, Youngkyu, Seoul 06772 (KR); LEE, Hyounjoo, Seoul 06772 (KR); LEE, Munsu, Seoul 06772 (KR)
(74) Representative: Vossius & Partner Patentanwälte Rechtsanwälte mbB
(86) International application number: PCT/KR2022/009263
(87) International publication number: WO 2024/005222

(57) **Abstract**

An apparatus for manufacturing a micro LED display according to the present embodiment comprises: a substrate chuck on which a substrate is seated; and a detaching head which detaches a donor that has transferred an LED chip to the substrate. The detaching head comprises: a main motor; a main elevating member which is moved up and down by the main motor; and a plurality of sub-modules installed on the main elevating member. Each of the plurality of sub-modules comprises: a sub-motor disposed on the main elevating member; a sub-elevating member connected to the sub-motor; a suctioning body that is disposed on the sub-elevating member and pre-separates the donor by suctioning the upper surface of the donor; and a donor gripper that is disposed on the sub-elevating member and grips the rim of the donor.

## Description

### [Technical Field]

The present disclosure relates to an apparatus for manufacturing a micro-LED display.

### [Background Art]

Recently, display devices with good characteristics such as thinness and flexibility are being developed in the display technology field. The major displays currently commercialized are represented by LCD (Liquid Crystal Display) and AMOLED (Active Matrix Organic Light Emitting Diodes).

However, LCD has problems such as slow response time and difficulty in implementing flexibility, and AMOLED has vulnerabilities such as short lifespan and poor mass production yield.

Meanwhile, light-emitting diodes (LEDs) are well-known semiconductor light-emitting elements that convert current into light. Starting with the commercialization of red LEDs using GaAsP compound semiconductors, they have been used as light sources for display images in electronic devices including information and communication devices along with green LEDs of the GaP:N series. Therefore, a method can be proposed to solve the above problems by implementing a display (i.e., LED display) using the above semiconductor light-emitting elements. These light-emitting diodes have various advantages compared to filament-based light-emitting devices, such as long life, low power consumption, excellent initial driving characteristics, and high vibration resistance.

Meanwhile, micro-LEDs (µLEDs) with a size of 10 to 100 micrometers (µm), which are 1/10th the length and 1/100th the area of general light-emitting diode (LED) chips, are gradually increasing.

These micro-LEDs (µLEDs) have the advantages of faster response speed, lower power, higher brightness, and not breaking when applied to displays when bent, compared to conventional LEDs.

A display device using the micro-LED (µLED) can perform an LED chip transfer process in which an LED chip is provided to a donor and then the LED chip provided to the donor is transferred back to a substrate.

After the LED chip transfer process is completed, a donor stripping process in which the donor is removed from the substrate can be performed.

### [Invention]

### [Technical Problem]

The present embodiment provides an apparatus for manufacturing a micro-LED display capable of reliably detaching a donor by adsorbing and gripping the donor onto which an LED chip is transferred to a substrate.

### [Technical Solution]

An apparatus for manufacturing a micro-LED display according to an aspect of embodiments may include a substrate chuck on which a substrate is mounted; and a detaching head for detaching a donor having an LED chip transferred to the substrate, wherein the detaching head includes: a main motor; a main lifting member elevated by the main motor; and a plurality of sub-modules installed on the main lifting member, and wherein each of the plurality of sub-modules includes: a sub-motor arranged on the main lifting member; a sub-lifting member connected to the sub-motor; a suction body arranged on the sub-lifting member and adsorbing an upper surface of the donor to pre-peel the donor; and a donor gripper arranged on the sub-lifting member and gripping an edge of the donor.

The main motor may elevate the main lifting member after the gripper completes gripping the donor.

Each of the plurality of sub-modules may include a plurality of the suction bodies, and wherein the plurality of suction bodies may be mounted to the sub-lifting member so as to be separated from each other.

The separation direction of the plurality of sub-modules and the separation direction of the plurality of suction bodies may be orthogonal to each other.

The donor gripper may include: at least one gripping member; and an X-axis actuator for moving the gripping member in a direction orthogonal to a lifting direction of the sub-lifting member.

The plurality of sub-modules may move forward and backward the gripping member of a left sub-module toward a right sub-module, and move forward and backward the gripping member of the right sub-module toward the left sub-module.

The donor gripper may further include a Z-axis actuator for moving the gripping member in a direction parallel to the lifting direction of the sub-lifting member.

The donor gripper may operate after the suction body absorbs the upper surface of the donor.

The detaching head may include: a lifting guide; a screw connected to the main motor; and a lifting connector coupled to the main lifting member and lifts and lowers along the screw.

The apparatus for manufacturing a micro-LED display may further include a donor unloader for unloading the donor, and wherein the detaching head may transfer the donor to the donor unloader.

### [Effect of the Invention]

According to an embodiment of the present disclosure, after the suction body absorbs the upper surface of the donor, the donor gripper can grip the donor, so that the donor can be gripped reliably.

In addition, since multiple sub-modules can be lifted together by the main motor and the main lifting member, the number of parts is minimized and the structure is simple.

In addition, since the suction body and the donor gripper can be lifted together by the sub-motor and the sub-lifting member, the number of parts is minimized and the structure is simple.

### [Description of Drawings]

FIG. 1 is a perspective view of an apparatus for manufacturing a micro-LED display according to the present embodiment.
FIG. 2 is a plan view of an apparatus for manufacturing a micro-LED display according to the present embodiment.
FIG. 3 is a diagram illustrating a transfer process by an apparatus for manufacturing a micro-LED display according to the present embodiment.
FIG. 4 is a perspective view of a panel stage according to the present embodiment.
FIG. 5 is a perspective view of a panel pop-up mechanism according to the present embodiment.
FIG. 6 is a front view of the panel pop-up mechanism according to the present embodiment when the substrate is bent.
FIG. 7 is a perspective view of an aligner according to the present embodiment.
FIG. 8 is a perspective view illustrating a panel vision alignment mechanism according to the present embodiment.
FIG. 9 is a perspective view of a transfer head according to the present embodiment.
FIG. 10 is a perspective view illustrating an adsorption plate of a transfer head according to the present embodiment.
FIG. 11 is a perspective view illustrating an adsorption plate and a light source of a transfer head according to the present embodiment.
FIG. 12 is a perspective view illustrating a drive module of a transfer head according to the present embodiment.
FIG. 13 is a perspective view illustrating a lifting mechanism of a transfer head according to the present embodiment.
FIG. 14 is a perspective view of a detaching head according to the present embodiment.
FIG. 15 is a perspective view of a sub-module illustrated in FIG. 14.
FIG. 16 is a side view when a donor according to the present embodiment is peeled off from a substrate.
FIG. 17 is a perspective view of a donor gripper illustrated in FIG. 14.
FIG. 18 is a perspective view of a lifting mechanism of a detaching head according to the present embodiment.

### [Best Mode]

Hereinafter, specific embodiments of the present disclosure will be described in detail with drawings.

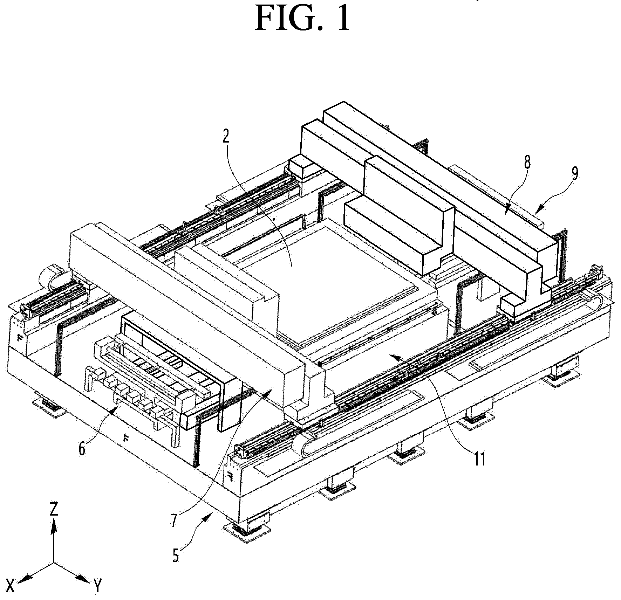

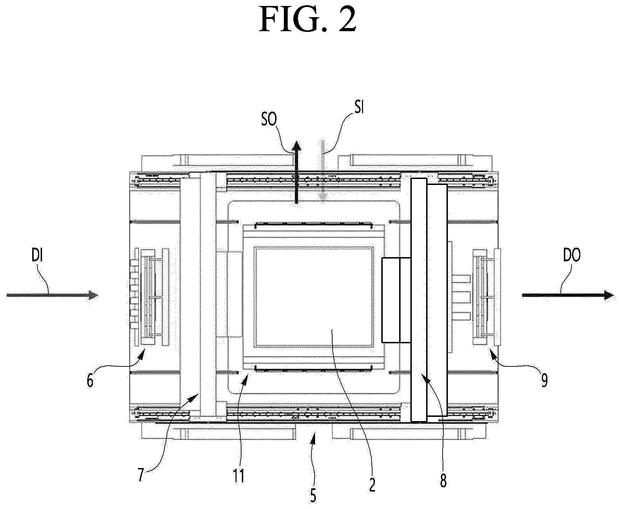

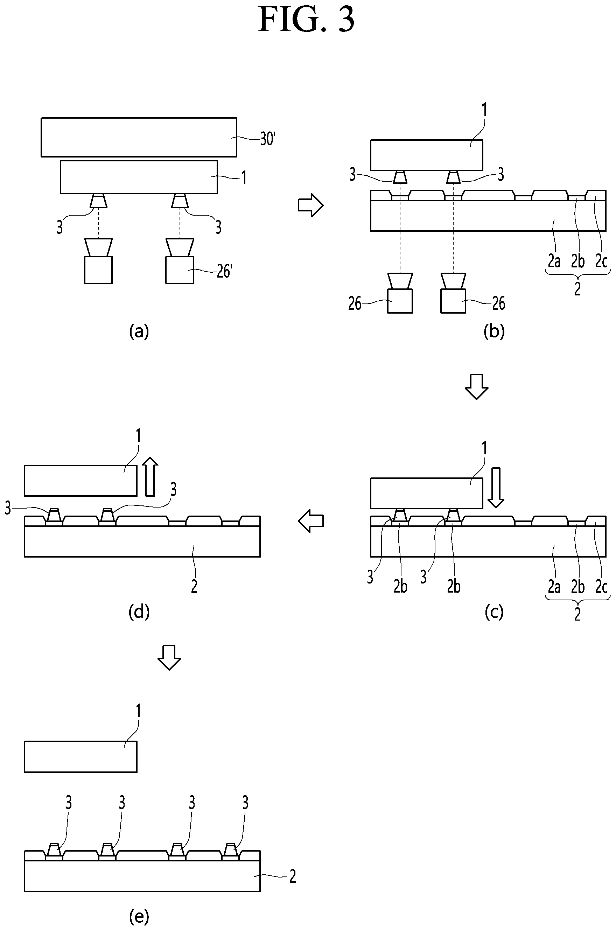

FIG. 1 is a perspective view of an apparatus for manufacturing a micro-LED display according to the present embodiment, FIG. 2 is a plan view of an apparatus for manufacturing a micro-LED display according to the present embodiment, and FIG. 3 is a diagram illustrating a transfer process by an apparatus for manufacturing a micro-LED display according to the present embodiment.

The apparatus for manufacturing a micro-LED display may transfer an LED chip 3 provided to a donor 1 (see FIG. 3) to a substrate 2. The apparatus for manufacturing a micro-LED display may be a transfer device that transfers the LED chip 3 to the substrate 2.

The apparatus for manufacturing a micro-LED display may include a panel stage 5, a donor loader 6, a transfer head 7, a detaching head 8, and a donor unloader 9, as shown in FIGS. 1 and 2.

The donor 1 may be an interposer provided with an LED chip 3 on one side. The donor 1 may be loaded onto the substrate 2 to transfer the LED chip 3 onto the substrate 2. The donor 1 is preferably formed of a transparent material or a translucent material.

The donor 1 may be provided with an align key, and may be loaded into the apparatus for manufacturing a micro-LED display while the align key is provided.

The drawing symbol Dl illustrated in FIG. 2 indicates a direction in which the donor 1 is loaded onto the substrate 2, and the drawing symbol DO illustrated in FIG. 2 indicates a direction in which the donor 1 is unloaded from the substrate 2.

The substrate 2 may be mounted on the panel stage 5, as illustrated in FIGS. 1 and 2.

An example of the substrate 2 may include a panel 2a and an adhesive 2b formed on an upper surface of the panel 2a, as shown in FIG. 3.

An example of the panel 2a may be a CID panel. The material of the panel 2a may be a glass material. It is preferable that the panel 2a is formed of a transparent material or a translucent material.

A plurality of adhesives 2b may be formed on the upper surface of the panel 2a, and the plurality of adhesives 2b may be separated from each other.

Among the substrates 2, the panel 2a may be mounted on the panel stage 5, and the panel 2a may be chucked to the panel stage 5.

An example of the substrate 2 may further include a light guide 2c. The light guide 2c may be a partition wall that partitions the LED chip 3. The light guide 2c may be a reflective layer or reflective sheet that reflects the light of the LED chip 3.

When the substrate 2 is mounted on the panel stage 5, the light guide 2c may be formed in a plurality of numbers on the upper surface of the panel 2a, and the plurality of adhesives 2b may be spaced apart from each other by the light guide 2c. When a plurality of LED chips 3 is transferred to the substrate 2, the light guide 2c may be positioned between the multiple LED chips 3.

An align key may be provided on the substrate 2, and the substrate may be loaded onto the panel stage 5 while the align key is provided.

The drawing symbol SI illustrated in FIG. 2 indicates the direction in which the substrate 2 is loaded onto the panel stage 5, and the drawing symbol SO illustrated in FIG. 2 indicates the direction in which the substrate 2 is unloaded on the panel stage 5.

The substrate 2 may be advanced in the front-back direction Y above the panel stage 5 as shown in FIG. 2, and may be retracted in the front-back direction Y above the panel stage 5.

A plurality of LED chips 3 may be provided on the donor 1. The LED chip 3 provided on the donor 1 may be a micro-LED chip, and a plurality of micro-LED chips may be provided on one surface of the donor 1. The LED chips 3 may be loaded into the apparatus for manufacturing a micro-LED display while being provided on the bottom surface of the donor 1.

Hereinafter, the configuration of the apparatus for manufacturing a micro-LED display will be described.

The panel stage 5 may include a substrate chuck 11 on which the substrate 2 is mounted.

The substrate chuck 11 may be positioned between the donor loader 6 and the donor unloader 9 in the left-right direction X, and may horizontally chuck the substrate 2. As shown in FIGS. 1 and 2, the substrate 2 may receive the LED chip 3 from the donor 1 while being placed on the substrate chuck 11.

The panel stage 5 may align the position of the substrate 2. The panel stage 5 may simultaneously align the substrate 2 and the donor 1. The panel stage 5 may absorb the substrate 2 and may absorb a large substrate.

The panel stage 5 may be formed long in the left-right direction X. The panel stage 5 may be formed long in the front-back direction Y. The left-right direction X length of the panel stage 5 may be longer than the front-back direction Y length of the panel stage 5. The panel stage 5 may have a rectangular shape that is elongated in the left-right direction X when viewed from above.

The donor loader 6 may load the donor 1. The donor loader 6 may load the donor 1 to the transfer head 7.

The donor loader 6 may be placed on the panel stage 5, and the donor loader 6 may be eccentrically placed on one side (for example, the right side) of the left and right sides of the panel stage 6. The donor loader 6 may be spaced apart from the substrate chuck 11 and the donor unloader 9 in the left-right direction X.

The donor loader 6 may include a reverser that may reverse the donor 1. The donor loader 6 may include a rotating device that may rotate the donor 1. The donor loader 6 may reverse and rotate the donor 1.

The donor loader 6 may include a barcode recognition unit that recognizes a barcode formed on the donor 1, and may recognize the barcode while tracking the donor 1. The donor loader 6 may align the position of the donor 1. The donor loader 6 may align the donor 1 prior to the transfer head 7 adsorbing the donor 1.

The donor 1 may be adsorbed on an adsorption plate 30' (Vacuum plate) as shown in a of FIG. 3, and may be sensed by a vision sensor 20'. The vision sensor may perform a pre-vision align that senses the LED chip 3 provided on the bottom surface of the donor 1 and the donor 1.

As shown in (a) of FIG. 3, the suction plate 30' may be the suction plate 30 of the transfer head 7, or may be provided separately from the suction plate 30 of the transfer head 7.

As shown in (a) of FIG. 3, a vision sensor 26' may be a vision sensor 26 arranged on the lower side of the substrate chuck 11, or may be provided separately from the vision sensor 26 arranged on the lower side of the substrate chuck 11.

The transfer head 7 may transfer the LED chip 3 provided on the donor 1 to the substrate 2.

After receiving the donor 1 of the donor loader 6, the transfer head 7 may transfer the LED chip 3 to the substrate 2.

The transfer head 7 may absorb the donor 1 and lift and lower the absorbed donor 1. The transfer head 7 may be movably arranged on the panel stage 5. The transfer head 7 may be arranged to move in the left-right direction X on the panel stage 5.

The transfer head 7 may correct the parallelism between the donor 1 and the substrate 2. The transfer head 7 may be controlled in the Z-axis (up-down direction) for each bonding section.

The transfer head 7 may be moved to the upper side of the donor loader 6 and may be moved to the upper side of the substrate chuck 11.

The transfer head 7 may move the donor 1 to the upper position of the substrate 2, as shown in (b) of FIG. 3, and may lower the donor 1 to the substrate 2 from the upper position of the substrate 2. The transfer head 7 may adjust the angle of the donor 1, and the donor 1 may be adjusted to be parallel to the substrate 2.

A plurality of transfer heads 7 may be provided. The plurality of transfer heads 7 may be arranged in a row. The plurality of transfer heads 7 may be arranged in a row in the front-back direction Y.

The apparatus for manufacturing a micro-LED display may include a transfer head mounter on which the plurality of transfer heads 7 is mounted, and the plurality of transfer heads 7 may be arranged in a row in the front-back direction Y on the transfer head mounter.

The apparatus for manufacturing a micro-LED display may further include a transfer head mounter moving mechanism that moves the transfer head mounter in the left-right direction X. The transfer head mounter moving mechanism may be mounted on the panel stage 2. The transfer head mounter moving mechanism may include a driving source such as a motor, and at least one power transmission member connected to the driving source and the transfer head mounter. The transfer head mounter moving mechanism may include a linear guide that guides the power transmission member.

The detaching head 8 may detach the donor 1 on which the LED chip 3 is transferred to the substrate 2. The detaching head 8 may remove the donor 1 from which the LED chip 3 is separated (i.e., transfer is completed). The detaching head 8 may remove the donor 1 from which the LED chip 3 is separated (i.e., transfer is completed) by adsorbing/gripping the donor 1. The detaching head 8 may transport the donor 1 located on the upper side of the substrate 2 to the donor unloader 9.

The detaching head 8 may be movably arranged on the panel stage 5. The transfer head 7 may be arranged to move in the left-right direction X on the panel stage 5.

The detaching head 8 may be moved to the upper side of the donor unloader 9. The detaching head 8 may transfer the donor 1 on the upper side of the substrate chuck 11 to the donor unloader 9.

A plurality of detaching heads 8 may be provided. The plurality of detaching heads 8 may be arranged in a row. The plurality of detaching heads 8 may be arranged in a row in the front-back direction Y.

The apparatus for manufacturing a micro-LED display may include a detaching head mounter on which the plurality of detaching heads 8 is mounted, and the plurality of detaching heads 8 may be arranged in a row in the front-back direction Y on the detaching head mounter.

The apparatus for manufacturing a micro-LED display may further include a detaching head mounter moving mechanism that moves the detaching head mounter in the left-right direction X. The detaching head mounter moving mechanism may be mounted on the panel stage 2. The detaching head mounter moving mechanism may include a driving source such as a motor, and at least one power transmission member connected to the driving source and the detaching head mounter. The detaching head mounter moving mechanism may include a linear guide that guides the power transmission member.

The donor unloader 9 may unload the donor 1.

The donor unloader 9 may be placed on the panel stage 5, and the donor unloader 9 may be eccentrically placed on the other side for example, the left side of the panel stage 6. The donor unloader 9 may be spaced apart from the substrate chuck 11 and the donor unloader 9 in the left-right direction X.

The donor unloader 9 may align the donor 1. The donor unloader 9 may include a reverser that may reverse the donor 1. The donor unloader 9 may include a rotation device that may rotate the donor 1. The donor unloader 9 may reverse and rotate the donor 1.

The apparatus for manufacturing a micro-LED display may include a vision sensor 20 (see (b) of FIG. 3) placed under the substrate chuck 11.

The vision sensor 26 may capture an image of the substrate 2 and an image of the LED chip 3 at a lower position of the substrate 2 mounted on the substrate chuck 11. The vision sensor 26 may capture an image of the LED chip 3 located on the lower surface of the donor 1 through an area opening or transparent portion of the substrate chuck 11 through which light may pass, and may capture the panel 2.

The apparatus for manufacturing a micro-LED display may correct the position of the LED chip 3, the angle of the donor 1, or the position of the substrate 2 according to the sensing result of the vision sensor 26, and may transfer the LED chip 3 to the correct position on the substrate 2.

The apparatus for manufacturing a micro-LED display may be positioned on the upper side of the substrate 2 as shown in (b) of FIG. 3 after the substrate 2 is placed on the substrate chuck 11 of the panel stage 5 as shown in FIG. 1 and FIG. 2. Thereafter, the donor 1 may be lowered to the substrate 2 as shown in (c) of FIG. 3 to transfer the LED chip 3 to the substrate 2, especially the adhesive 2b, and the LED chip 3 may be adhered to the substrate 2 by the adhesive 2b, as shown in (d) of FIG. 3. Thereafter, the donor 1 may be raised away from the substrate 2 as shown in (e) of FIG. 3 and may be removed from the substrate 2.

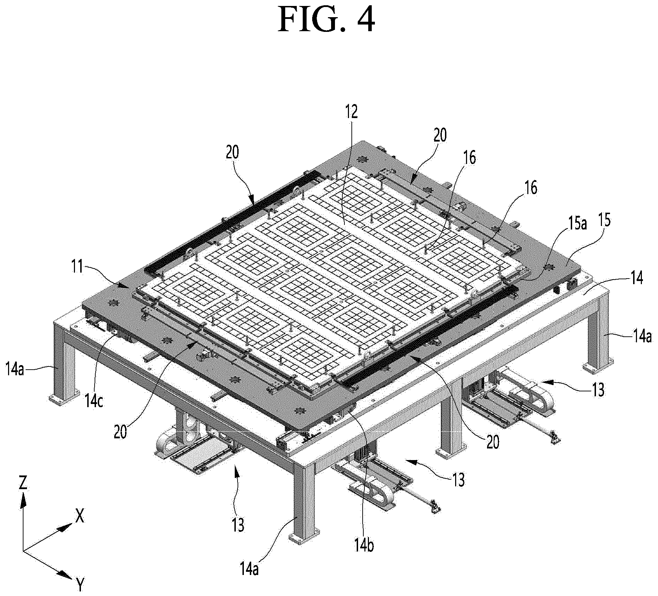

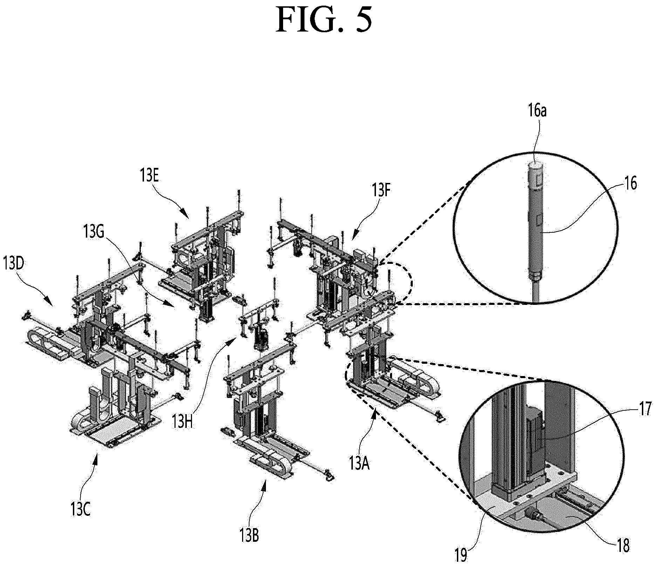

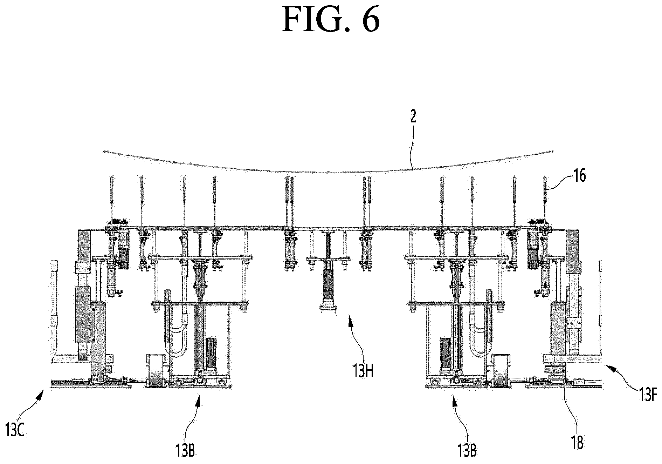

FIG. 4 is a perspective view of a panel stage according to the present embodiment. FIG. 5 is a perspective view of a panel pop-up mechanism according to the present embodiment, and FIG. 6 is a front view of the panel pop-up mechanism according to the present embodiment when the substrate is bent.

The substrate chuck 11 may include a panel chuck 12 and a panel pop-up mechanism 13, as shown in FIG. 4.

The panel stage 5 may further include a table 14 having legs 14a, as shown in FIG. 4, and the substrate chuck 11 may be placed on the table 14.

The substrate chuck 11 may further include a mounting member 15 and a transfer mechanism 14b and 14c.

The mounting member 15 may be placed on the table 14, and a panel chuck mounting portion 15a on which the panel chuck 12 is mounted may be formed on the mounting member 15. The panel chuck mounting portion 15a may be formed to protrude from the upper surface of the mounting member 15. The panel chuck mounting portion 15a may have an opening or transparent portion formed in the center. The panel chuck 12 may be mounted on the panel chuck mounting portion 15a in an area close to the edge.

The mounting member 15 may be arranged to be horizontally movable on the table 14. The transfer mechanism 14b and 14c such as a motor for moving the mounting member 15 may be mounted on the table 14. The transfer mechanism 14b and 14c such as a motor may include a left-right transfer mechanism that may move the mounting member 15 in the left-right direction X. The transfer mechanism 14b and 14c such as a motor may include a back-and-forth transfer mechanism that may move the mounting member 15 in the front-back direction Y.

The panel chuck 12 may be mounted on the panel chuck mounting portion 15a and supported on the mounting member 15. The panel chuck 12 may be placed on the table 14.

A plurality of suction holes may be formed on the panel chuck 12. The panel chuck 12 may be a vacuum plate that absorbs the substrate 2.

A suction tube may be connected to the panel chuck 12. The suction tube may be connected to the suction hole of the panel chuck 12 and the suction device. The substrate 2 placed on the upper surface of the panel chuck 12 may be absorbed by the panel chuck 12 by the suction tube and the suction device.

The panel chuck 12 may be divided into multiple regions. A plurality of suction holes may be formed in each of the multiple regions. An example of the multiple regions may be 12 regions. The panel chuck 12 may flatly adsorb or air-float the substrate 2.

The panel chuck 12 may be positioned above the vision sensor 26 and may cover the vision sensor 26 from the upper side.

The panel chuck 12 may be formed of a ceramic series material or a reinforced glass material. An example of the panel chuck 12 may be a Pyrex material. The panel chuck 12 may be transparent or translucent.

It is preferable that the panel chuck 12 satisfies the transparency condition that allows the precision vision of the vision sensor 26 to pass through. The panel chuck 12 is applied with a Pyrex material, and the upper surface of the Pyrex may be polished.

Meanwhile, a pin through hole through which a pin 16 of the panel pop-up mechanism 13 penetrates may be formed in the panel chuck 12. The pin through hole may be spaced apart from the suction hole that suctions the substrate 2.

The panel pop-up mechanism 13 may be a mechanism that may elevate or bend the substrate 2 mounted on the panel chuck 12.

The panel pop-up mechanism 13 may include the pin 16, as shown in FIGS. 4 to 6. The pin 16 may be positioned so as to be liftable on the panel chuck 12. The pin 16 may protrude upwardly from the panel chuck 12 through the pin through hole of the panel chuck 12 and may be lowered into the pin through hole of the panel chuck 12. This pin 16 may elevate the substrate 2 positioned on the panel chuck 12.

An upper end 16a of the pin 16 may be curved. The upper end 16a of the pin 16 may be a contact surface that comes into contact with the substrate 2, and when the upper end 16a of the pin 16 is curved, the contact area between the substrate 2 and the pin 16 may be minimized.

The panel pop-up mechanism 13 may include a driving source 17 such as a motor or cylinder that raises and lowers the pin 16. The driving source 17 may be configured as a servo motor that raises and lowers the pin 16, and may control the pin 16 in the Z-axis servo. The driving source 17 and the pin 16 may be connected by a power transmission member.

The power transmission member may convert the rotational motion of the driving source 17 into the up-and-down linear motion of the pin 16, and may include a gear, a link, a screw, a belt, or the like. The power transmission member is not limited to the type as long as it may convert the rotational motion of the driving source 17 into the up-and-down linear motion of the pin 16.

The panel pop-up mechanism 13 may include a pop-up base 18. The pop-up base 18 may support the panel pop-up mechanism 13. The pop-up base 18 may be placed on the ground.

A pop-up frame 19 may be placed on the pop-up base 18. The pop-up frame 19 may be a combination of multiple members.

The panel pop-up mechanism 13 may include a plurality of pins 16 and a plurality of driving sources 17.

The panel pop-up mechanism 13 may include a plurality of pop-up units 13A, 13B, 13C, 13D, 13E, 13F, 13G, and 13H including the pin 16 and the driving source 17.

In the case that the eight pop-up units 13A, 13B, 13C, 13D, 13E, 13F, 13G, and 13H are provided, the panel pop-up mechanism 13 may lift and lower eight areas of the substrate 2 differently.

The plurality of pop-up units 13A, 13B, 13C, 13D, 13E, 13F, 13G, and 13H may control multiple pop-up units 13A, 13B, 13C, 13D, 13E, 13F, 13G, and 13H so that the upper height of some of the multiple pins 16 is different from the upper height of the remaining pins 16.

The plurality of pop-up units 13A, 13B, 13C, 13D, 13E, 13F, 13G, and 13H may include outer pop-up units 13A, 13B, 13C, 13D, 13E, and 13F that include the pin 16a that contacts an area close to the edge of the substrate 2, and inner pop-up units 13G and 13H that include the pin 16a that contacts an area close to the center of the substrate 2.

The pin 16 elevation height of the inner pop-up units 13G and 13H may be lower than the pin 16 elevation height of the outer pop-up units 13A, 13B, 13C, 13D, 13E, and 13F. In this case, the substrate 2 may be supported in a shape in which the height of the edge is higher than the height of the center, and the substrate 2 may be bent in a shape close to a U-shape.

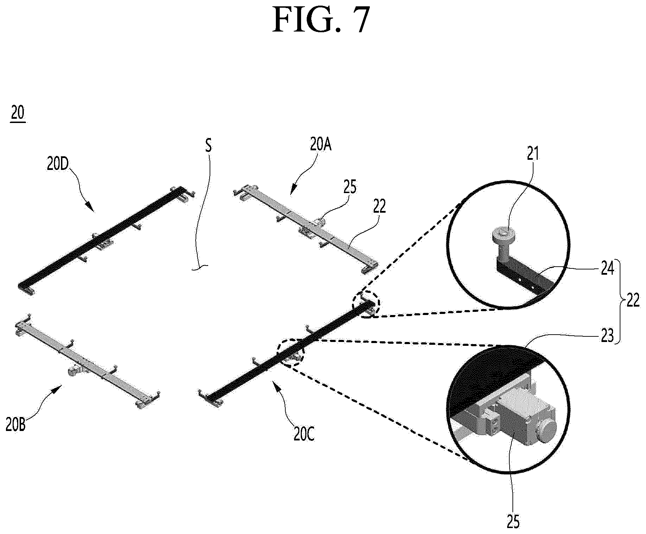

FIG. 7 is a perspective view of an aligner according to the present embodiment.

The substrate chuck 11 may further include an aligner 20 for aligning the substrate 2. The aligner 20 may be provided in multiple numbers on the panel chuck 12.

The plurality of aligners 20 may be arranged around the panel chuck 12, as shown in FIG. 4.

The plurality of aligners 20 may include a left aligner 20A and a right aligner 20B spaced apart in the left-right direction X and may include a front aligner 20C and a rear aligner 20D spaced apart in the front-back direction Y.

The plurality of aligners 20 may be spaced apart from each other. A panel chuck receiving space S in which the panel chuck 12 is received may be formed between the left aligner 20A, the right aligner 20B, the front aligner 20C, and the rear aligner 20D.

The aligner 20 may include a urethane roller 21, a link 22 on which the urethane roller 21 is arranged, and a motor 25 that operates the link 22.

The outer peripheral surface of the urethane roller 21 may be in contact with the peripheral surface of the substrate 2 or the peripheral surface of the panel chuck 12.

The link 22 may include a main link 23 arranged along the periphery of the panel chuck 12, and a plurality of sub-links 24 arranged on the main link 23 and facing the periphery of the panel chuck 12.

The urethane roller 21 may be rotatably mounted on the sub-link 24. The urethane roller 21 may be spaced apart from the main roller 23.

An example of the motor 25 may be a servo motor and may be servo controlled. The motor 25 may rotate or linearly move the link 22.

Each of the substrate 2 and the panel chuck 12 may include four peripheries left periphery, right periphery, front periphery, rear periphery. The urethane roller 21 of each of the plurality of aligners 20 may be in contact with the circumference of the substrate 2 or the circumference of the panel chuck 12.

In the case that the plurality of aligners 20 include the urethane roller 21, when the substrate 2 is aligned by the plurality of aligners 20, damage to the substrate 2 made of glass may be minimized.

The plurality of aligners 20 may align four circumferential surfaces with respect to the mounting position of the substrate 2, and the substrate 2 may be individually aligned on four surfaces, and the alignment position may be adjusted by servo control.

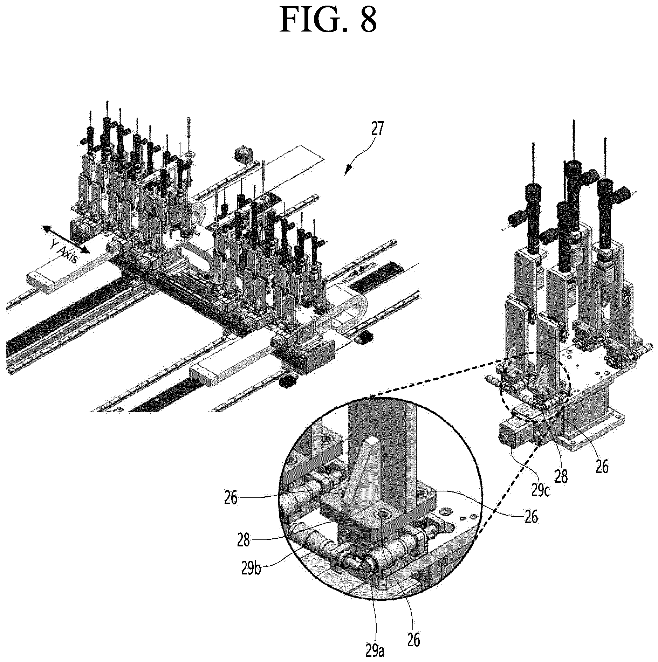

FIG. 8 is a perspective view illustrating a panel vision alignment mechanism according to the present embodiment.

The apparatus for manufacturing a micro-LED display may include a panel vision alignment mechanism 27 including a vision sensor 26.

The vision alignment mechanism 27 may simultaneously photograph the alignment key of the substrate 2 and the alignment key of the donor 1 from the lower portion of the substrate 2, and the apparatus for manufacturing a micro-LED display may simultaneously correct the donor 1 and the substrate 2.

The vision sensor 26 may include a high-resolution camera sensor, and may be adjusted to a right angle of within 5 µm.

The vision alignment mechanism 27 may include four high-resolution camera sensors as a set, and may be configured to individually drive one set of the four high-resolution camera sensors in the X-axis, Y-axis, and Z-axis.

The vision alignment mechanism 27 may include a vision sensor mounter 28 having the vision sensor 26 installed therein, and may include an X-axis driving unit 29a capable of driving the vision sensor mounter 28 along the X-axis, a Y-axis driving unit 29b capable of driving the vision sensor mounter 28 along the Y-axis, and a Z-axis driving unit 29c capable of driving the vision sensor mounter 28 along the Z-axis.

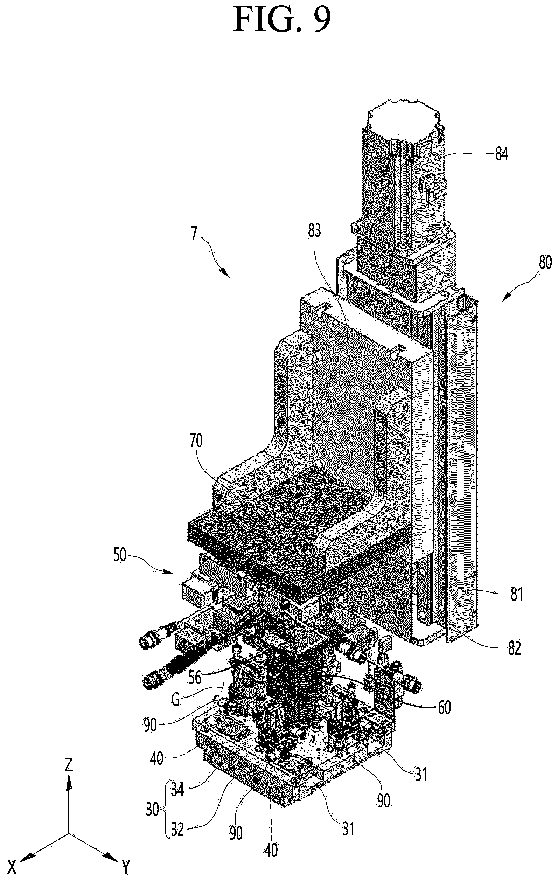

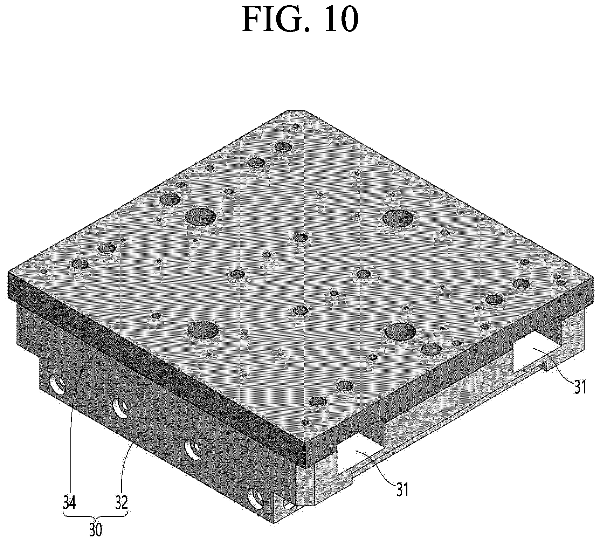

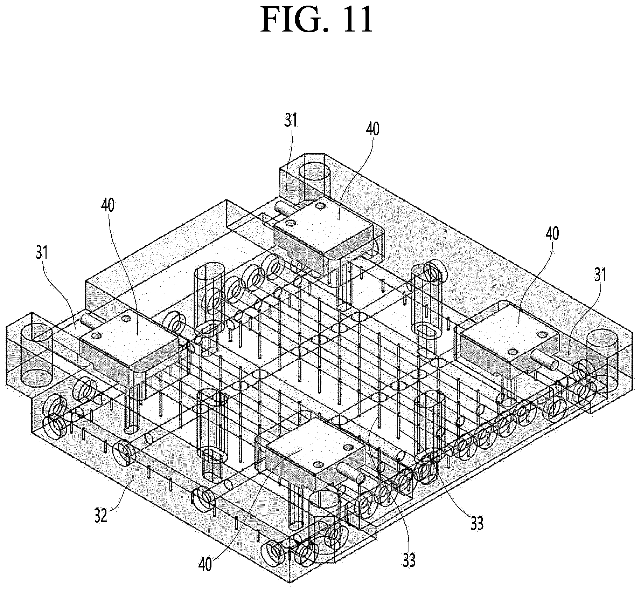

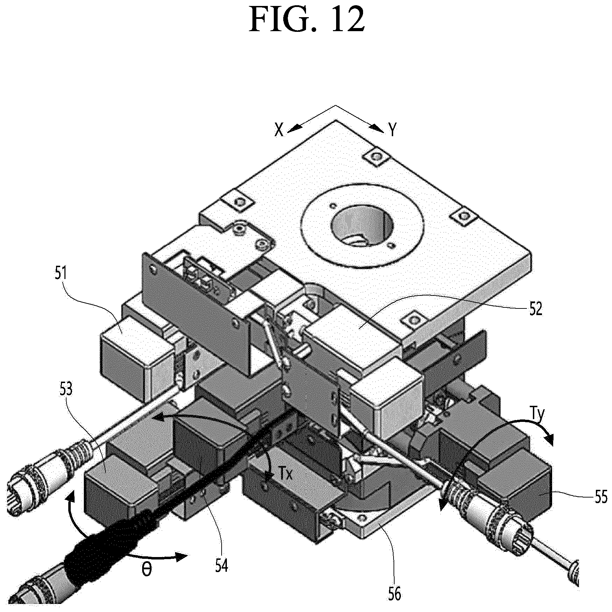

FIG. 9 is a perspective view of a transfer head according to the present embodiment, FIG. 10 is a perspective view illustrating an adsorption plate of a transfer head according to the present embodiment, FIG. 11 is a perspective view illustrating an adsorption plate and a light source of a transfer head according to the present embodiment, and FIG. 12 is a perspective view illustrating a drive module of a transfer head according to the present embodiment.

The transfer head 7 may include a suction plate 30 to which the donor 1 is sucked.

A light source 40 that irradiates light toward the donor 1 may be placed on the suction plate 30.

A light source receiving portion 31 in which a light source 40 is inserted and received may be formed on the suction plate 30.

The suction plate 30 may be a combination of multiple members, and the suction plate 30 may include a suction plate 32 and a fixed plate 34. The suction plate 30 may have an overall hexahedral shape.

The suction plate 32 may have a plurality of suction holes 33 (see FIG. 11). The suction holes 33 may be formed through the suction plate 32. The upper surface of the donor 1 may be absorbed by the lower surface of the suction plate 32.

It is preferable that the suction hole 33 has a diameter capable of absorbing the donor 1.

It is preferable that the suction plate 32 itself be configured to ensure the flatness of the donor 1 when absorbing the donor 1. An example of the diameter of the suction hole 33 may be 0.7 mm. The suction plate 32 may be a vacuum plate in which a plurality of suction holes 33 having a diameter of 0.7 mm are formed.

The light source receiving portion 31 may be formed in the suction plate 32. The light source receiving portion 31 may be formed in a sunken shape in the suction plate 32, as illustrated in FIG. 11. The light source receiving portion 31 may be in the form of an upper surface and a side surface open to the suction plate 32. A plurality of light source receiving portions 31 may be formed on the suction plate 32, and the plurality of light source receiving portions 31 may be formed to be spaced apart from each other.

The light source receiving portion 31 may be formed to be spaced apart from the suction hole 33.

The suction plate 32 is configured to have a structure in which light generated from the light source 40 may be irradiated downward, and the suction plate 32 may have an opening formed on the lower side of the light source receiving portion 31 through which light is transmitted, or a transparent portion may be arranged.

The light source 40 may be configured as a white back light that allows the vision sensor 26 to simultaneously recognize the alignment key of the substrate 2 and the alignment key of the donor 1.

In the case that the light source 40 is not located below the substrate chuck 11 but above the donor 1, the light source 40 may be closer to the donor 1, and the vision sensor 26 may sense the alignment key of the donor 1 and the alignment key of the substrate 2 with greater reliability.

A plurality of light sources 40 may be provided on the suction plate 32. It is preferable that at least four light sources 40 are provided.

The fixed plate 34 may be placed on the upper surface of the suction plate 32, as shown in FIG. 10. The fixed plate 34 may cover the upper surface of the suction plate 32. The fixed plate 34 may be fastened to the suction plate 32 with a fastening member such as a screw.

The fixed plate 34 may cover the light source receiving portion 31. The light source 40 may be hidden by the fixed plate 34.

The fixed plate 34 may be connected to the connecting bracket 60 (see FIG. 9) of the transfer head 7.

The transfer head 7 may further include a driving module 50, a connecting bracket 60, a lifting plate 70, and a lifting mechanism 80, as shown in FIG. 9.

The driving module 50 may be arranged on the upper side of the connecting bracket 60 and may be connected to the connecting bracket 60. An output shaft 56 of the driving module 50 may be connected to the connecting bracket 60.

The driving module 50 may have an X-axis driving source 51, a Y-axis driving source 52, a θ-axis driving source 53, a Tx-axis driving source 54, and a Ty-axis driving source 55, as shown in FIG. 12. The driving module 50 may be a 5-axis module capable of moving and rotating the connecting bracket 60 along 5 axes. The drive module 50 may move the output shaft 56 along the X-axis, Y-axis, and rotate the Tx-axis, Ty-axis, and θ-axis.

The X-axis movement may be the left-right direction X movement of the output shaft 56, and the Y-axis movement may be the front-back direction Y movement.

The θ-axis rotation may be the rotation around the vertical first center axis of the output shaft 56.

The Tx-axis rotation may be the rotation of the output shaft 56 around the horizontal second center axis, but the second center axis may be the center axis of the left-right direction X.

The Ty-axis rotation may be the rotation of the output shaft 56 around the horizontal third center axis, but the third center axis may be the center axis of the front-back direction Y.

As shown in FIG. 9, the driving module 50 may be spaced apart from the suction plate 50 in the upper side of the suction plate 30 in the up-down direction Z, and a gap G may be formed between the suction plate 30 and the driving module 50.

The upper part of the connecting bracket 60 may be connected to the driving module 50, and the lower part may be connected to the suction plate 30. The connecting bracket 60 may be long in the vertical direction, and the driving module 50 and the suction plate 30 may be spaced apart from each other in the vertical direction by the connecting bracket 60.

The upper part of the connecting bracket 60 may be connected to the output shaft 56 of the driving module 50. The lower part of the connecting bracket 60 may be connected to the fixed plate 34.

The lifting plate 70 may be placed on the upper part of the driving module 50. The driving module 50 may be installed on the lifting plate 70 so as to be hung on the lifting plate 70. The size of the lifting plate 70 may be larger than the size of the driving module 50, and the driving module 50 may be protected by the lifting plate 70.

The lifting mechanism 80 may be a Z-axis mover that may move the driving module 50 in the Z-axis direction.

The lifting mechanism 80 may be connected to the lifting plate 70 and may elevate the lifting plate 70. The lifting mechanism 80 is not limited to its type as long as it has a configuration that may lift the lifting plate 70.

An example of the lifting mechanism 80 may include a lifting guide 81, a lifting plate 82 guided by the lifting guide 81, a connecting member 83 connecting the lifting plate 82 and the lifting plate 70, and a lifting driving source 84 that generates a driving force to lift the lifting plate 82.

The lifting guide 81 may be an LM guide formed long in the vertical direction.

The lifting guide 81 may be mounted on a transfer head mounter.

An example of the lifting driving source 84 may be a servo motor.

The transfer head 7 may further include a displacement sensor 90. The displacement sensor 90 may calculate the height or inclination between the substrate 2 and the donor 1.

An example of the displacement sensor 90 may be a laser displacement sensor, and a spectral sensor with a resolution of 0.25 µm may be applied to the laser displacement sensor. The displacement sensor 90 may have a manual stage structure that allows precise adjustment for the X-axis, Y-axis, and Z-axis.

The displacement sensor 90 may irradiate a laser to the donor 1 or the substrate 2 through the opening of the suction plate 30 from the upper side of the suction plate 30, and may sense the distance between the donor 1 and the substrate 2 or the degree of inclination of the donor 1 or the substrate 2.

The displacement sensor 90 may be accommodated in the gap G between the suction plate 30 and the driving module 50, and may be protected by the suction plate 30 and the driving module 50.

The displacement sensor 90 may be positioned around the connecting bracket 60, and a plurality of displacement sensors 90 may be arranged around the connecting bracket 60. A plurality of displacement sensors 90 may be arranged spaced apart from each other around the connecting bracket 60.

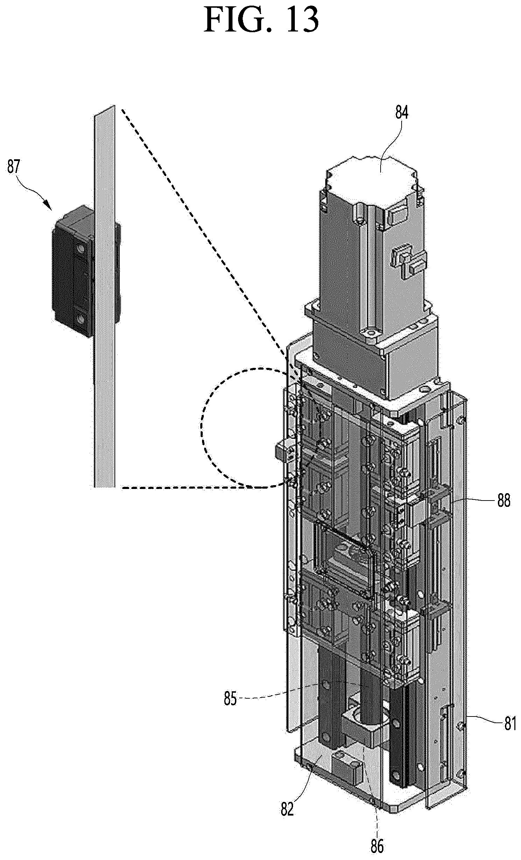

FIG. 13 is a perspective view illustrating a lifting mechanism of a transfer head according to the present embodiment.

The lifting mechanism 80 of the transfer head 7 may further include a screw 85 and a lifting connector 86.

The screw 85 may be connected to a lifting drive source 84. The screw 85 may be formed to be long in the up-down direction Z and may be connected to a rotational axis of the lifting drive source 84.

The lifting connector 86 may be lifted along the screw 85 and connected to the lifting plate 82.

When the lifting drive source 84 is driven, in the case that the screw 85 rotates, the lifting connector 86 may be lifted along the outer circumference of the screw 85.

The lifting mechanism 80 of the transfer head 7 may further include an encoder scale 87.

The encoder scale 87 may be a scale of a full closed control method to control within 0.1 µm through a precision scale, and may be precisely driven in the Z-axis direction of the suction plate 30.

The lifting mechanism 80 of the transfer head 7 may further include a photo sensor 88. The photo sensor 88 may sense the lifting plate 82, and the apparatus for manufacturing a micro-LED display may control the lifting height of the lifting plate 82.

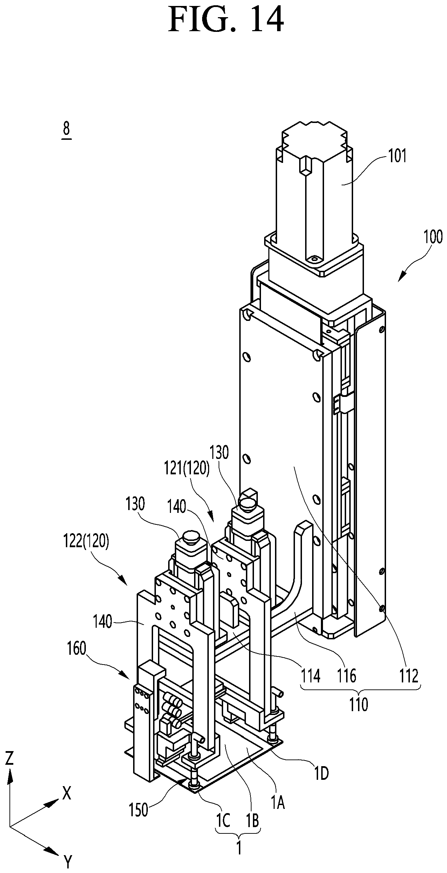

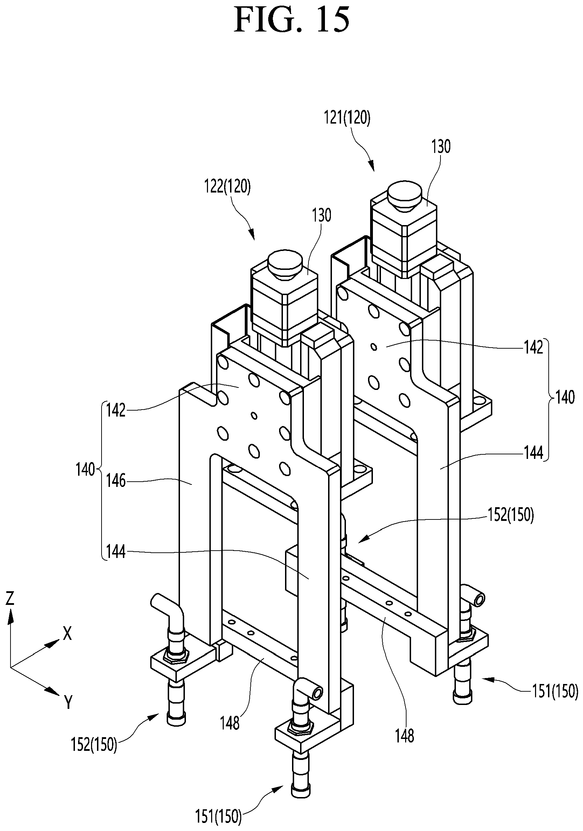

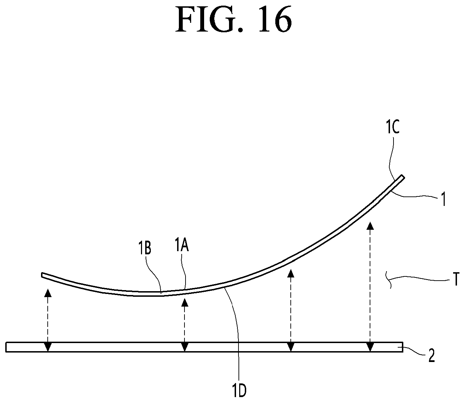

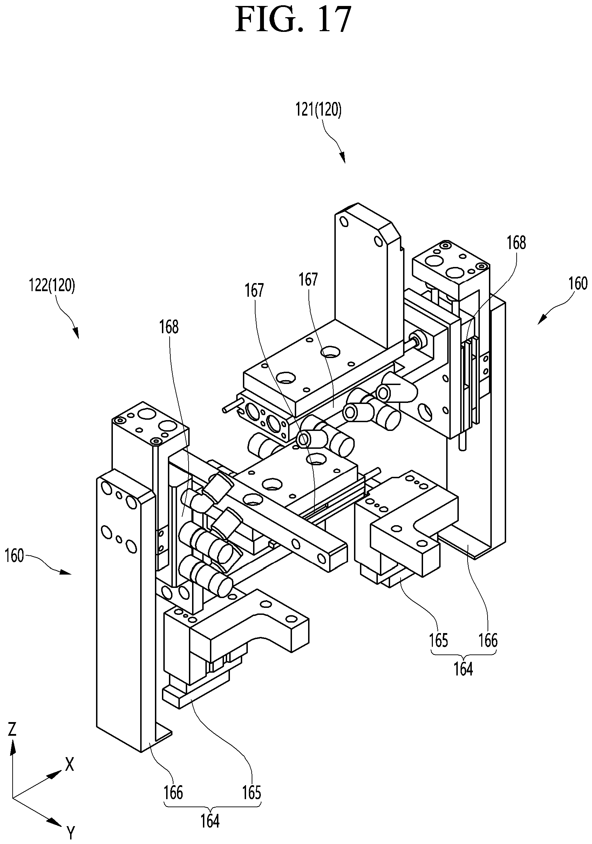

FIG. 14 is a perspective view of a detaching head according to the present embodiment, FIG. 15 is a perspective view of a sub-module illustrated in FIG. 14, FIG. 16 is a side view when a donor according to the present embodiment is peeled off from a substrate, and FIG. 17 is a perspective view of a donor gripper illustrated in FIG. 14.

The detaching head 8 may include a lifting mechanism 100, a main lifting member 110, and a plurality of sub-modules 120.

The lifting mechanism 100 may include a main motor 101. An example of the main motor 101 may be a servo motor. The lifting mechanism 100 may be a Z-axis mover capable of moving the plurality of sub-modules 120 together in the Z-axis direction.

The lifting mechanism 100 is not limited to the type as long as it may elevate the main lifting member 110 and the plurality of sub-modules 120.

The main lifting member 110 may be elevated by the lifting mechanism 100, particularly the main motor 101.

The main lifting member 110 may be configured as a combination of multiple members. The main lifting member 110 may include a vertical plate 112 that is long in the up-down direction Z, and a horizontal plate 114 connected to the lower portion of the vertical plate 112.

The vertical plate 112 may be the same as the lifting plate 82 (see FIG. 9) of the transfer head 7.

The vertical plate 112 may be arranged on the left or right side of the lifting mechanism 100, and may be raised by the lifting mechanism 100 to raise the horizontal plate 124.

The horizontal plate 114 may be a sub-module mounter in which the plurality of sub-modules 120 are mounted together. The horizontal plate 114 may be orthogonal to the vertical plate 112. A sub-module mounting portion in which the sub-module is mounted may be formed on the horizontal plate 114.

The main lifting member 110 may further include the vertical plate 112 and the horizontal plate 114 and a reinforcing bracket 116 that is connected to reinforce strength.

The plurality of sub-modules 120 may be installed on the main lifting member 110. The plurality of sub-modules 120 may be lifted together when the main lifting member 110 is lifted. The plurality of sub-modules 120 may be spaced apart from each other. The plurality of sub-modules 120 may be installed spaced apart in the left and right direction X on the main lifting member 110, especially on the horizontal plate 114.

Each of the plurality of sub-modules 120 may remove the donor 1 by absorbing and gripping the donor 1, and may be an absorbing and gripping mechanism.

An example of the plurality of sub-modules 120 may include a left sub-module 121 and a right sub-module 122.

The left sub-module 121 may absorb and grip the left side of the donor 1 based on the center of the donor 1, and the right sub-module 122 may absorb and grip the right side of the door 1 based on the center of the donor 1.

The donor 1 may be rectangular or square overall, and as shown in FIG. 14, its upper surface 1A may face upward, and its lower surface 1D may face the substrate 2.

As shown in FIG. 14, the donor 1 may have a central portion 1B and a border portion 1C outside the central portion 1B.

The central portion 1B of the donor 1 may be defined as a portion including the exact center of the donor 1, and the border portion 1C of the donor 1 may be defined as an area including the border of the donor 1 and close to the border of the donor 1.

Each of the plurality of sub-modules 120 may include a sub-motor 130 arranged on the main lifting member 110, a sub-lifting member 140 connected to the sub-motor 130, a suction body 150 arranged on the sub-lifting member 140 and adsorbing the upper surface 1C of the donor 1 to separate the donor 1, and a donor gripper 160 arranged on the sub-lifting member 140 and gripping the border portion of the donor 1.

The detaching head 8 may grip the edge 1C of the donor 1 that is adsorbed by the suction body 150 after the suction body 150 adsorbs the upper surface 1A of the donor 1, and the detaching head 8 may reliably and quickly detach the donor 1.

The sub-motor 130 may be arranged on the upper surface of the horizontal plate 114 of the main lifting member 110, as shown in FIG. 14.

The sub-motor 130 may be directly connected to the sub-lifting member 140, or may be connected to the sub-lifting member 140 through a power transmission member such as a gear or screw. The sub-motor 130 and the power transmission member are not limited to the type as long as they may raise and lower the sub-lifting member 140 in the up-and-down direction.

The sub-lifting member 140 may be arranged lengthwise in the up-down direction Z, as shown in FIG. 15.

The sub-lifting member 140 may include a connecting member 142 connected to the sub-motor 130 or the power transmission member.

The sub-lifting member 140 may include a pair of leg members 144 and 146 extending downward from the lower portion of the connecting member 142. The pair of leg members 144 and 146 may be spaced apart in the front-back direction Y.

The sub-lifting member 140 may include a bracket 148 connected to the lower portion of the pair of leg members 144 and 146. A donor gripper mounting portion may be formed on the bracket 148 to which the donor gripper 160 is mounted. An example of the donor gripper mounting portion may be a fastening hole to which the donor gripper 160 may be mounted using a screw, and the like.

The suction body 150 may be lifted to the donor 1 on the upper side of the substrate 2 by the sub-motor 130, and may come into contact with the upper surface 1A of the donor 1, as illustrated in FIG. 14.

The upper surface 1A of the donor 1 may be sucked onto the suction body 150 by the suction body 150, the suction tube, and the suction device.

An example of the suction body 150 may be a vacuum tube or an adsorption pipe capable of adsorbing a donor 1. A suction tube may be connected to the suction body 150. The suction tube may be connected to the suction body 150 and a suction device.

Each of the plurality of sub-modules 120 may include a plurality of suction bodies 150, as illustrated in FIG. 15. The plurality of suction bodies 150 may be mounted spaced apart from each other on the sub-lifting member 140. The plurality of suction bodies 150 may be spaced apart in the front-back direction Y.

An example of the plurality of suction bodies 150, as illustrated in FIG. 15, may include a front suction body 151 and a rear suction body 152 separated from the front suction body 151 in the front-back direction Y.

The separation direction (Y) of the plurality of suction bodies 151 and 152 may be orthogonal to the separation direction (X) of the plurality of sub-modules 121 and 122.

In the case that one sub-module 120 includes the front suction body 151 and the rear suction body 152, the detaching head 8 may include a total of four suction bodies 150, and the detaching head 8 may more stably absorb the donor 1 even in the case that the area of the donor 1 is large.

The donor gripper 160 may be composed of a combination of multiple members, and as shown in FIG. 17, may further include at least one gripping member 164, an X-axis actuator 167, and a Z-axis actuator 168.

At least one gripping member 164 may grip the edge portion 1C, see FIG. 16 of the donor 1 by pressing it upward and downward.

An example of the gripping member 164 may include an upper gripping member 165 and a lower gripping member 166. At least one of the upper gripping member 165 or the lower gripping member 166 may move in the horizontal and vertical directions, and the edge portion 1C of the donor 1 may be gripped by the upper gripping member 165 and the lower gripping member 166 between the upper gripping member 165 and the lower gripping member 166.

As an example, the upper gripping member 165 may be fixed to the sub-lifting member 140 and the lower gripping member 166 may be arranged to be movable in the horizontal and vertical directions.

As another example, the lower gripping member 166 may be fixed to the sub-lifting member 140 and the lower gripping member 166 may be arranged to be movable in the horizontal and vertical directions.

As another example, each of the upper gripping member 165 and the lower gripping member 166 may be arranged to be movable in the horizontal and vertical directions on the sub-lifting member 140.

The X-axis actuator 167 may move the gripping member 164 in a direction X orthogonal to the lifting direction Z of the sub-lifting member 140. The X-axis actuator 167 may be configured with a motor, a hydraulic cylinder, a pneumatic cylinder, a valve, or the like that may move all or part of the gripping member 164 in the left-right direction X.

The Z-axis actuator 168 may move the gripping member 164 in a direction Z parallel to the lifting direction Z of the sub-lifting member 140. The Z-axis actuator 168 may be configured with a motor, a hydraulic cylinder, a pneumatic cylinder, a valve, etc. that may lift all or part of the gripping member 164 in the up-down direction Z.

The X-axis actuator 167 and the Z-axis actuator 168 may be connected to one another. The Z-axis actuator 168 may lift the X-axis actuator 167, or the X-axis actuator 167 may move the Z-axis actuator 168 in the left-right direction.

When the lower gripping member 166 moves horizontally, the X-axis actuator 167 may move the lower gripping member 166 in the horizontal direction X, for example, in the left-right direction.

When the lower gripping member 166 moves vertically, the Z-axis actuator 168 may raise and lower the lower gripping member 166 in the up-down direction Z.

The plurality of sub-modules 120 may move forward and backward the gripping member 164 of the left sub-module 121 toward the right sub-module 122. The plurality of sub-modules 120 may move forward and backward the gripping member 164 of the right sub-module 122 toward the left sub-module 121 among the plurality of sub-modules 120.

For example, the left sub-module 121 may move the lower gripping member 166 among the gripping members 164 in the left-right direction X. And, the right sub-module 122 may move the lower gripping member 166 among the gripping members 164 in the left-right direction X.

In the case that the lower gripping member 166 of the left sub-module 121 and the right sub-module 122 are moved close to each other, they may support the lower surface 1D (see FIG. 16) of the edge 1C of the donor 1.

The donor gripper 160 may be operated after the suction body 150 suctions the upper surface 1A of the donor 1.

As shown in FIG. 16, a gap T may be formed between the edge 1C of the donor 1 of which upper surface 1A is adsorbed on the suction body 150 and the substrate 2, and the lower gripping member 166 among the gripping members 164 may enter between the donor 1 and the substrate 2 through the gap T and stably grip the donor 1 at the lower side of the donor 1.

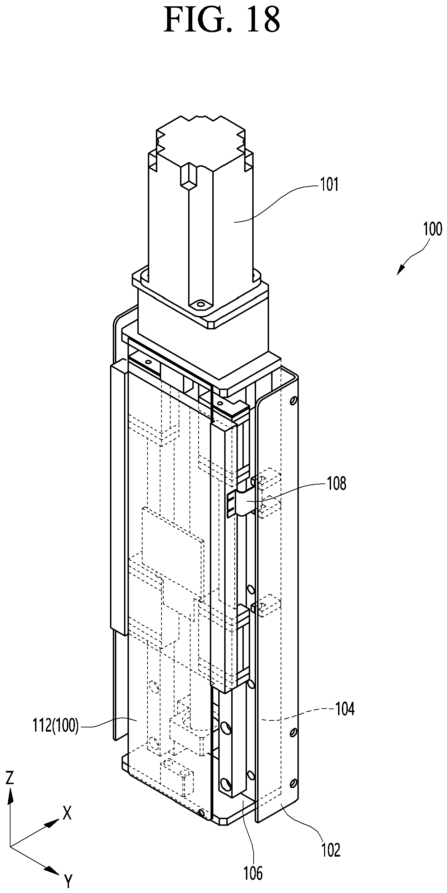

FIG. 18 is a perspective view of a lifting mechanism of a detaching head according to the present embodiment.

The detaching head 8 may include a lifting guide 102, a screw 104 connected to the main motor 101 and a lifting connector 106 coupled to the main lifting member 110 and raised and lowered along the screw 104.

The main motor 101 may raise the main lifting member 110 after the donor gripper 160 has completed gripping the donor 1.

The lifting guide 102 may be mounted on the detachable head mounter. The lifting guide 81 may be an LM guide formed long in the vertical direction.

A space in which a screw 104 is accommodated may be formed between the lifting guide 102 and the vertical plate 112 of the main lifting member 110.

The screw 104 may be connected to the main motor 101. The screw 104 may be formed long in the up-down direction Z and may be connected to the rotation axis of the main motor 101.

The main motor 101, the lifting guide 102, the screw 104, and the lifting connector 106 may constitute the lifting mechanism 100.

The lifting mechanism 100 of the detaching head 8 may be configured identically or similarly to the lifting mechanism 90 of the transfer head 7, and the manufacturer may reduce costs through common use of parts.

The lifting mechanism 100 may include a photo sensor 108. The photo sensor 109 may sense the main lifting member 110. The photo sensor 88 may sense the main lifting member 110, and the apparatus for manufacturing a micro-LED display may control the lifting height of the main lifting member 110.

The above description is merely an example of the technical idea of the present disclosure, and those with ordinary knowledge in the technical field to which the present disclosure belongs may make various modifications and variations without departing from the essential characteristics of the present disclosure.

Therefore, the embodiments disclosed in the present disclosure are not intended to limit the technical idea of the present disclosure, but to explain it, and the scope of the technical idea of the present disclosure is not limited by these embodiments.

The protection scope of the present disclosure should be interpreted by the claims below, and all technical ideas within the equivalent scope should be interpreted as being included in the scope of the rights of the present disclosure.

## Claims

1. An apparatus for manufacturing a micro-LED display, comprising:
a substrate chuck on which a substrate is mounted; and
a detaching head for detaching a donor having an LED chip transferred to the substrate,
wherein the detaching head comprises:
a main motor;
a main lifting member elevated by the main motor; and
a plurality of sub-modules installed on the main lifting member, and
wherein each of the plurality of sub-modules comprises:
a sub-motor arranged on the main lifting member;
a sub-lifting member connected to the sub-motor;
a suction body arranged on the sub-lifting member and adsorbing an upper surface of the donor to pre-peel the donor; and
a donor gripper arranged on the sub-lifting member and gripping an edge of the donor.

2. The apparatus according to claim 1, wherein the main motor lifts the main lifting member after the gripper completes gripping the donor.

3. The apparatus according to claim 1, wherein each of the plurality of sub-modules includes a plurality of the suction bodies, and wherein the plurality of suction bodies is mounted to the sub-lifting member so as to be separated from each other.

4. The apparatus according to claim 3, wherein the separation direction of the plurality of sub-modules and the separation direction of the plurality of suction bodies are orthogonal to each other.

5. The apparatus according to claim 1, wherein the donor gripper includes:
at least one gripping member; and
an X-axis actuator for moving the gripping member in a direction orthogonal to a lifting direction of the sub-lifting member.

6. The apparatus according to claim 5, wherein the plurality of sub-modules moves forward and backward the gripping member of a left sub-module toward a right sub-module, and moves forward and backward the gripping member of the right sub-module toward the left sub-module.

7. The apparatus according to claim 5, wherein the donor gripper further includes a Z-axis actuator for moving the gripping member in a direction parallel to the lifting direction of the sub-lifting member.

8. The apparatus according to claim 1, wherein the donor gripper operates after the suction body absorbs the upper surface of the donor.

9. The apparatus according to claim 1, wherein the detaching head includes:
a lifting guide;
a screw connected to the main motor; and
a lifting connector coupled to the main lifting member and lifts and lowers along the screw.

10. The apparatus according to claim 1, further comprising a donor unloader for unloading the donor, and
wherein the detaching head transfers the donor to the donor unloader.
